# EUROPEAN PATENT SPECIFICATION

(11) **EP 3 617 351 B1**
(45) Date of publication and mention of the grant of the patent: **22.12.2021**
(21) Application number: 17907677.3
(22) Date of filing: 03.08.2017
(51) Int. Cl.: C30B 15/06, C30B 15/02, C30B 29/06, C30B 15/14, C30B 15/00

(54) **SILICON WAFER HORIZONTAL GROWTH DEVICE AND METHOD**
VORRICHTUNG UND VERFAHREN ZUR HORIZONTALEN ZÜCHTUNG EINES SILIZIUMWAFERS
DISPOSITIF ET PROCÉDÉ DE CROISSANCE HORIZONTALE DE TRANCHE DE SILICIUM

(30) Priority: 28.04.2017 CN 201710300122
(43) Date of publication of application: 04.03.2020
(73) Proprietor: Changzhou University, Changzhou, Jiangsu 213164 (CN); Jiangsu University, Zhenjiang, Jiangsu 212013 (CN)
(72) Inventor: DING, Jianning, Changzhou Jiangsu 213164 (CN); YUAN, Ningyi, Changzhou Jiangsu 213164 (CN); XU, Jiawei, Changzhou Jiangsu 213164 (CN); SHEN, Dapeng, Changzhou Jiangsu 213164 (CN); XU, Xiaodong, Changzhou Jiangsu 213164 (CN); SUN, Tao, Changzhou Jiangsu 213164 (CN); WANG, Shubo, Changzhou Jiangsu 213164 (CN)
(74) Representative: Balder IP Law, S.L.
(86) International application number: PCT/CN2017/095869
(87) International publication number: WO 2018/196215

(56) References cited:
- WO-A1-2014/034028
- CN-A- 1 047 541
- CN-A- 102 925 986
- CN-A- 102 959 137
- CN-A- 104 011 270
- CN-A- 106 350 866
- CN-A- 106 521 622
- JP-A- H0 741 393
- JP-A- 2016 108 204
- Alison S Greenlee: "Towards the Development of a Horizontal Ribbon Growth Process to Produce Thin, Monocrystalline Silicon Sheets via the Stabilization of the (111) Plane in Undercooled Melts ARCHNES MAS$ACHUSETTS INSTITUTE OF TECHNOLOGY OCT 01 2015 LIBRARIES S ig n a tu r", Dissertation, 1 October 2015 (2015-10-01), pages 1-139, XP055738643, Massachusetts Institute of Technology Retrieved from the Internet: URL:https://dspace.mit.edu/bitstream/handl e/1721.1/101533/939922165-MIT.pdf?sequence =1&isAllowed=y [retrieved on 2020-10-12]

## Description

### BACKGROUND OF THE INVENTION

### Field of the Invention

The present application relates to the field of silicon material fabricating technology, and in particular, to a silicon wafer horizontal growth apparatus and method.

### Description of the Related Art

Silicon as a non-metal material has a wide range of applications in the semiconductor field as well as in the photovoltaic field. In the prior art, a monocrystalline silicon ingot is typically produced by a Czochralski method (CZ method) or a zone melting method (HZ method), and a polycrystalline silicon ingot is typically produced by a casting technique.

In the prior art, a silicon wafer having a certain thickness is obtained by a technique such as wire cutting, grinding and polishing, and the like, and a large amount of raw materials are wasted in the process of post-processing, thereby causing a substantial increase in the production cost of the silicon wafer. In order to reduce the loss of materials, various methods for direct fabrication of silicon wafers such as Edge-defined Film-fed Growth (EFG) and String Ribbon Growth (SR), have been developed, but mass production has not yet been achieved. In 1950, another method for the direct growth of silicon wafers, Horizontal Ribbon Growth (HRG), was proposed. Based on this method, an experimental fabrication apparatus was designed in 1960, but the horizontal growth of the silicon ribbon could not be achieved. In 2016, Clarkson University proposed a method for growing silicon wafers by horizontal floating silicon technique, and carried out numerical simulations and experiments, which are described in non-patent Document 1. However, the shape of the silicon wafer grown by the horizontal floating silicon technique has obvious defects and a large thickness, which requires subsequent cutting processing.

### Non-patent literature 1

Helenbrook B T, Kellerman P, Carlson F, et al. Experimental and numerical investigation of the horizontal ribbon growth process [J]. Journal of Crystal Growth, 2016, 453:163-172.

JP H 0741393 discloses a method and an apparatus for the horizontal growth of crystalline silicon.

### SUMMARY OF THE INVENTION

In view of the problems existing in the field of existing horizontally grown silicon wafers, such as unstable growth, large shape defects, and excessive thickness, the present application discloses an apparatus and a method for horizontally growing a silicon wafer continuously with a thickness controllable. The upper and lower radiant heating and jet cooling methods are used to control the temperature field and the flow field so as to control the thickness of the silicon wafer. The thickness of the silicon wafer is ensured to be uniform and the upper and lower surfaces of the silicon wafer are ensured to be smooth by using a multi-stage melting region and a two-stage overflow surface and by smoothing the temperature field by an external pumping gas.

A silicon wafer horizontal growth apparatus of the present application comprises: a casing forming a cavity; a crucible, located in the cavity and having a melting zone, an overflow port, a first overflow surface and a second overflow surface; a feeding assembly for adding silicon raw material to the melting zone at a feeding rate adjustable; a heating assembly comprising two movable heaters, the two movable heaters are disposed on the upper and lower sides of the crucible at a certain interval with the crucible; a thermal insulation component for maintaining a temperature in the cavity; a gas flow assembly comprising a jet, a gas conductive graphite member, a quartz exhaust tube, and a quartz cooling tube, wherein the jet is located above the second overflow surface, the gas conductive graphite member is mounted on the bottom of the crucible, the quartz cooling tube is nested outside the quartz exhaust tube, the quartz exhaust tube is connected with the gas conductive graphite member; and a heat insulating baffle located above the second overflow surface for isolating the heating assembly and the jet so that the cavity is divided into two temperature zones of a hot zone and a cold zone.

Preferably, the apparatus further comprises a receiving crucible located below an edge of the second overflow surface of the crucible.

Preferably, a heat conductive graphite plate is disposed between the heater and the crucible.

Preferably, a distance between the heater and the crucible is in a range of 1 to 5 mm.

Preferably, a distance between the jet and the second overflow surface is greater than 7 mm.

Preferably, the heat insulating baffle has a thickness in a range of 1 to 3 cm.

Preferably, a distance between the heat insulating baffle and the second overflow surface is in a range of 2 to 6 mm.

Preferably, the jet includes a gas inflow tube, a jet tube and a support tube, wherein two ends of the jet tube are respectively connected to the inflow tube and the support tube through a connecting member, and the jet tube has a double-layered structure with an outer layer being made of an isostatically pressed graphite material, and an inner layer being made of ceramic or high-density graphite material, and the jet tube is provided with a row of holes or a slit.

A method for horizontal growth of a silicon wafer of the present application comprises the steps of: a step of melting a silicon raw material including: adding the silicon raw material to a melting zone of a crucible through a feeding assembly; introducing a reducing gas into a cavity through a quartz cooling tube to place the cavity in a reducing atmosphere; then heating by a heater; when the temperature is stabilized at a set temperature and the silicon material is completely melted, a new silicon material is slowly added through a feeding port, so that the molten silicon material flows from an overflow port to a first overflow surface; as the silicon material gradually increases, the molten silicon gradually increases accordingly, the silicon material overflows to the second overflow surface smoothly; and a step of horizontal drawing of the silicon wafer, including: when the silicon material is about to reach a boundary between a cold zone and hot zone, a seed plate is inserted into the cavity, and a rate of feeding is slowed down, so that a melted material flows slowly to the seed plate in a thin layer; when the melted material contacts a seed ingot, the seed plate is pulled backward, and at the same time, the jet and the air pump are turned on, and a quartz exhaust tube is exhausted by pumping outwardly, and the quartz cooling tube is always kept in a ventilated state.

Preferably, an average temperature of the hot zone is in a range of 1500°C to 1600°C, and an average temperature of the cold zone is in a range of 800°C to 1000°C.

### BRIEF DESCRIPTION OF THE DRAWINGS

FIG. 1 is a functional block diagram of a silicon wafer horizontal growth apparatus according to an embodiment of the invention.
FIG. 2 is a front view of the silicon wafer horizontal growth apparatus.
FIG. 3 is a cabinet drawing of the silicon wafer horizontal growth apparatus.
FIG. 4 is a cabinet drawing of an assembly drawing of a crucible and a gas guiding graphite component of the silicon wafer horizontal growth apparatus.
FIG. 5 is a cabinet drawing of a jet assembly drawing of the silicon wafer horizontal growth apparatus.
FIG. 6 is a flow chart of a method of horizontal growth of a silicon wafer.

### DETAILED DESCRIPTION OF PREFERRED EMBODIMENTS OF THE IVENTION

In order to make clear the object, the technical solution and the advantages of the present invention, embodiments of the present invention will be clearly and completely described in the following with reference to the accompanying drawings. It should be understood that the examples herein are only intended to illustrate the invention and are not intended to limit the invention. The described embodiments are only a part of the embodiments of the invention, but not all of the embodiments. All other embodiments obtained by those skilled in the art based on the embodiments of the present invention without creative efforts are within the scope of the present invention.

It is to be understood that in the description of the present invention, the orientations or positional relationships of the terms "upper", "lower", "bottom", "horizontal", "inside", "outside", etc. are based on the orientation or positional relationships in the accompanying drawings, and are merely for the purpose of describing the present invention and simplifying the description, rather than indicating or implying that a device or a component must be in a particular orientation, be constructed or operate in a particular orientation. Thus, these terms should not be construed as liming the invention. Moreover, the terms "first" and "second" and the like are used for descriptive purposes only and are not to be construed as indicating or implying relative importance.

In the description of the present invention, it should be noted that the terms "assemble", "connect", and "couple" are to be understood broadly, unless otherwise specified or clearly defined. For example, they can refer to fixed or detachable connection, integral connection, mechanical or electrical connection; direct connection or indirect connection through an intermediate medium, or refer to internal communication of two components. For those skilled in the art, the specific meaning of the above terms in the present invention should be understood based on specific circumstances.

In addition, the present disclosure provides examples of various specific processes and materials, but the invention may be practiced without these specific details, as will be understood by those skilled in the art. Unless otherwise indicated below, various portions or components of the apparatus can be implemented using processes and materials well known in the art.

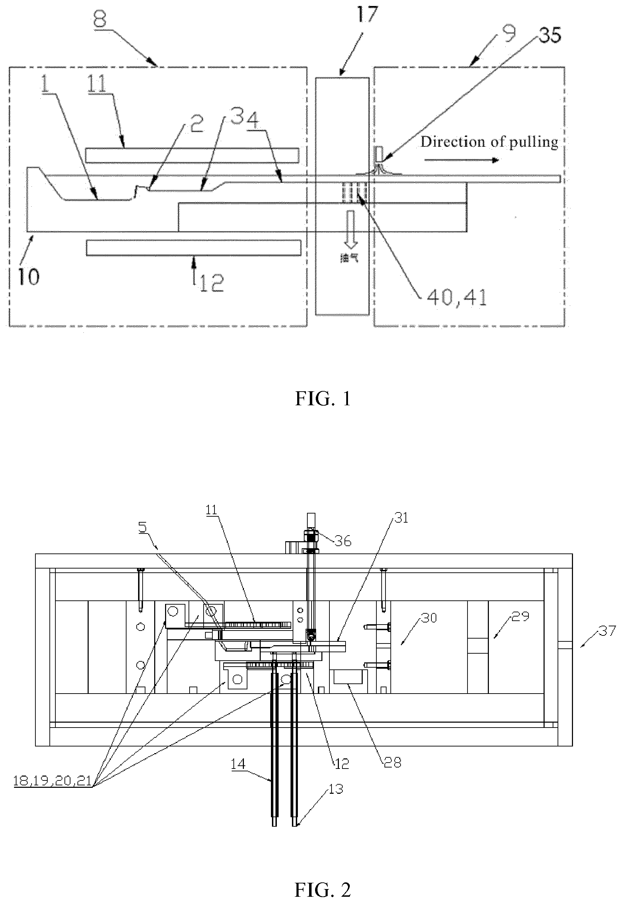

Figure 1 is a functional block diagram of a silicon wafer horizontal growth apparatus according to an embodiment of the present invention. The basic principle of the silicon wafer horizontal growth apparatus of the present invention will be described below with reference to FIG. 1. As shown in FIG. 1, a crucible 10 of the silicon wafer horizontal growth apparatus of the present invention has a melting zone 1, an overflow port 2, a first overflow surface 3, and a second overflow surface 4. These designs of multi-stage melting zones and two-stage overflow surfaces ensure the silicon wafer to have a uniform thickness and smooth upper and lower surfaces. A cavity of the apparatus is divided by a heat insulating baffle 17 into two temperature zones of a hot zone 8 and a cold zone 9. An upper heater 11 and a lower heater 12 are respectively disposed above and below the crucible 10 in the hot zone 8. A jet port 35 is provided above the second overflow surface 4 of the crucible 10 in the cold zone. By the upper and lower radiant heating and jet cooling, the temperature field and the flow field can be controlled, thereby the thickness of the silicon wafer can be controlled. Furthermore, the provision of ventilation holes 40, 41 ensures that a large amount of gas generated by the jet does not have too much influence on the pressure inside the cavity.

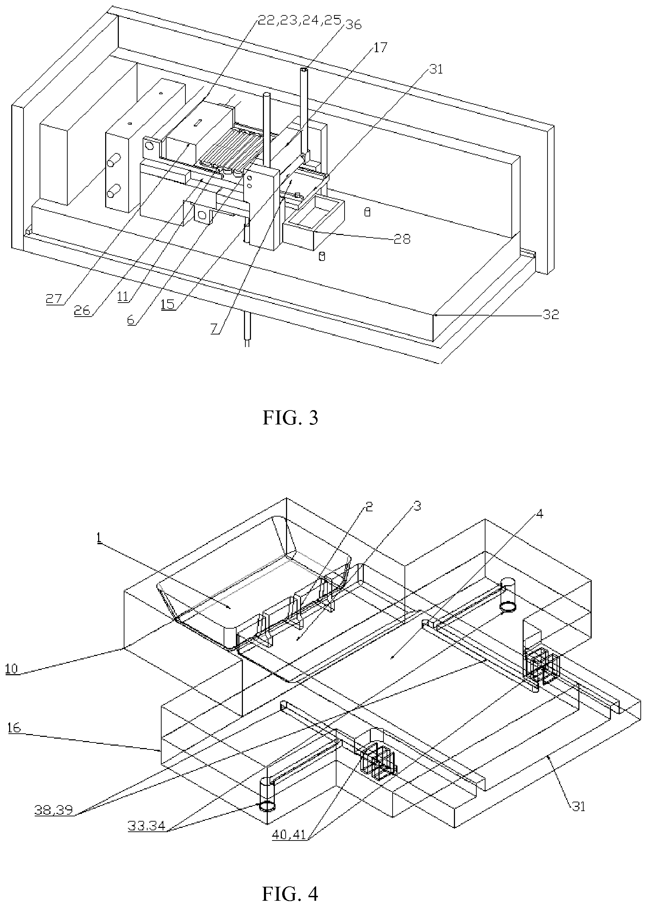

FIG. 2 is a front view of the silicon wafer horizontal growth apparatus of the present embodiment, FIG. 3 is a cabinet drawing of the silicon wafer horizontal growth apparatus, and FIG. 4 is a cabinet drawing of an assembly drawing of the crucible and the gas guiding graphite component of the silicon wafer horizontal growth apparatus. The specific structure of the silicon wafer horizontal growth apparatus of the present embodiment will be described in detail below with reference to FIGS. 2-4. As shown in FIG. 2, FIG. 3 and FIG. 4, the silicon wafer horizontal growth apparatus of the present embodiment comprises an aluminum casing (not shown), a water cooling device (not shown) for cooling the casing, the crucible 10, the upper heater 11, the lower heater 12, graphite heater guiding rails 18, 19, 20, 21, graphite electrodes 22, 23, 24, 25, a quartz exhaust tube 13, a quartz cooling tube 14, an jet 15, an gas guiding graphite element 16, an insulation baffle 17, an feeding graphite assembly 27, and a thermal insulation assembly. Among them, the graphite electrodes 22, 23, 24, 25 are connected to an external working circuit, and are connected to the wires for passing current through a specific connecting device. The thermal insulation assembly includes a bottom insulation member 32, a right inner insulation member 30, and a right outer insulation member 29. The thermal insulation component is made of heat insulating graphite felt to isolate part of heat of the thermal field from dissipating outward from the bottom of the outer casing and a crystal drawing opening.

As shown in Fig. 2, the silicon material enters from a feeding port 5 of the feeding graphite assembly 27, and is drawn out from an outlet 37 after the silicon wafer is formed. The upper heater 11 and the lower heater 12 are supported by graphite heater guiding rails 18, 19, 20, 21, and the two heaters can be moved on the guiding rails. This design allows the upper and lower heaters to form a thermal field environment required for different processes. Further, as shown in FIG. 2, the quartz cooling tube 14 may be nested outside the quartz exhaust tube 13. The quartz cooling tube 14 also cools the quartz exhaust tube 13 while introducing a reducing gas into the cavity, thereby ensuring that the quartz tube will not deform due to high temperature during the fabrication process.

As shown in FIG. 3, the crucible 10 is supported by the heat insulating member and is not in direct contact with the upper heater 11 and the lower heater 12. However, in order to ensure the heating efficiency, the heaters should be positioned as close as possible to the boundaries of the upper heating zone and the lower heating zone, and the spacing can be controlled in the range of 1 to 5 mm. A distance between the jet 15 and the second overflow surface 4 (i.e., the working surface) is typically greater than 7 mm so as to reduce the effect of the jet flow on the smoothness of the surface. The flow rate of the jet is adjustable so that different temperature gradients can be formed between the hot zone 8 and the cold zone 9 through different flow rates, and silicon bodies of different thicknesses can be prepared at a constant drawing speed. In addition, the jet 15 is half-wrapped by the heat insulating baffle 17 and the heat insulating members on both sides, and the lower end of the heat insulating baffle 17 is about 2 to 6 mm away from the second overflow surface 4. This design can prevent the flow field change caused by strong convection of the jet 15 from influencing the hot zone 8 and resulting in an uneven thermal field of the hot zone 8, while ensuring that the melt smoothly passes by. The insulating baffle 17 has a thickness in a range of 1 to 3 cm. A sufficient thickness can ensure that an excessive temperature gradient is not formed between the hot zone 8 and the cold zone 9. Such a design can effectively improve the stability of the thermal field of the hot zone 8, thereby making it easier to obtain a silicon wafer having a smooth appearance.

Further, the silicon wafer horizontal growth apparatus of the present invention may further include a thermal conductive graphite plate 26. As shown in FIG. 3, both the upper heater 11 and the lower heater 12 are meandering-type graphite heaters, and are made of isostatic pressure graphite such as G430. Since the heaters are of meandering type, it causes uneven radiation. Therefore, a high thermal conductive graphite plate 26 is added between the upper heater 11 and the surface of the crucible 10. The surface of the melt is heated by the heat conductive graphite plate, which can effectively solve the problem of uneven thermal field due to uneven radiation.

Further, the silicon wafer horizontal growth apparatus of the present invention further includes a receiving crucible 28. As shown in FIG. 3, due to the presence of the upper heater 11 and the lower heater 12 during the fabrication process, the heat supplied causes the crucible 10 to be in an "overheated" state, and there will be a thin liquid film between the formed silicon wafer and the second overflow surface 4. Therefore, a receiving crucible 28 is placed under an edge 31 of the crucible to prevent the outflowing solution from contaminating the insulating layer. At the edge 31 of the crucible, the edge is machined with a chamfer with an angle of 20° to 90°. This design allows a stable meniscus to be formed at the edge when the silicone fluid flows out.

As shown in FIG. 4, the gas conductive graphite member 16 is fitted at the bottom of the crucible 10. The crucible 10 includes a melting zone 1, an overflow port 2, a first overflow surface 3, and a second overflow surface 4. The gas conductive graphite member 16 is provided with a quartz exhaust tube connection ports 33, 34, a gas guiding grooves 38, 39 and a gas intake ports 40, 41. The quartz exhaust tube connection ports 33, 34 are connected to the quartz exhaust tube 13. The silicon material melted in the melting zone 1 flows out from the overflow port 2, and is buffered by the first overflow surface to weaken the liquid level fluctuation caused by the feeding, and then flows into the second overflow surface 4 to contact the seed crystal. Thereafter, the drawing process for a chip is started. During the drawing process, the infrared thermometer detects the hot zone temperature measurement point 6 and the cold zone temperature measurement point 7 (as shown in Fig. 3) respectively and feeds back to the system. At the same time, the gas jetted from the jet 15 is sucked through the intake ports 40, 41, and flows out from the connection ports 33, 34 through the guidance of the gas guide grooves 38, 39. During the drawing, the gas is pumped outward by the quartz exhaust tube 13 continuously so as to ensure that a large amount of gas generated by the jet flow will not have too much influence on the pressure in the furnace cavity. During this process, the tension formed by the pumping will make the connection between the gas conductive graphite member 16 and the crucible 10 tighter, and at the same time, the thermal field of the second overflow surface 4 will be smoother, and this design allows a stable growth of the silicon wafer during the drawing process so as to form a silicon wafer having a smooth surface topography.

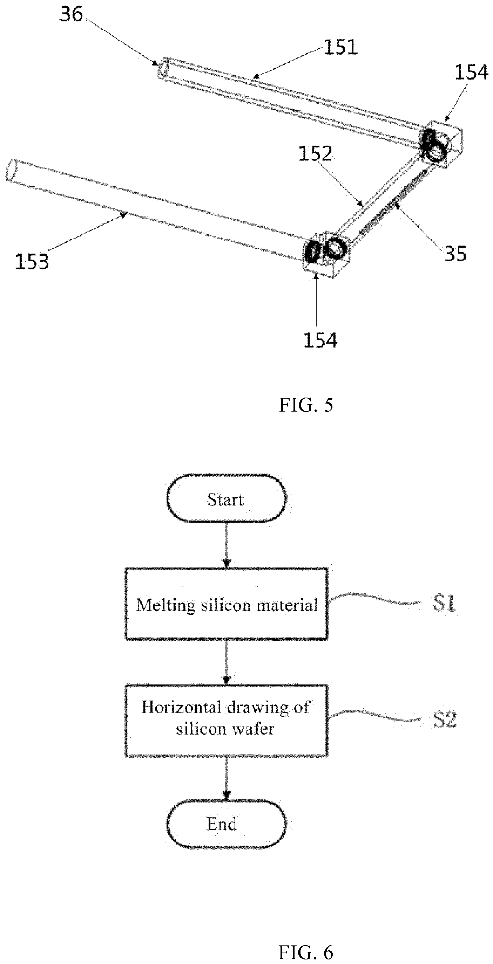

Figure 5 is a cabinet drawing of an assembly drawing of a jet of a silicon wafer horizontal growth apparatus. The specific structure of the jet will be described below with reference to FIG. 5. As shown in FIG. 5, the jet 15 includes a gas inflow tube 151, a jet tube 152, a support tube 153, and two connectors 154. The overall material of the jet 15 is isostatically pressed graphite. The presence of the support tube 153 ensures that the jet will not be damaged by vibration during the large flow gas jet, and the life of the jet can be effectively improved. The high-temperature gas required for the jet cooling is introduced from a jet gas introduction port 36 of the gas inflow tube 151. The jet tube 152 of the jet 15 has a two-layered structure, the outside layer is isostatically pressed graphite, the inner layer is nested with ceramic tube or high-density graphite. The nested structure can prevent the thermal stress caused by a large temperature gradient formed during passage of the jet gas from destroying the graphite structure. The jet port 35 may adopt a row of holes or a slit structure, and the jet 15 shown in Fig. 5 employs a jet port of a slit jet type. This design of the jet port can ensure the heat exchange amount without causing obvious shape defects of the drawn silicon wafer.

According to another aspect of the present invention, a method of horizontal growth of a silicon wafer is also disclosed. The details will be specifically described below with reference to FIG. 6. Figure 6 is a flow chart of a method of horizontal growth of a silicon wafer. First, in a step of melting silicon raw material S1, at first, the powdery silicon material is filled in the melting zone 1 in an amount of 100 to 180 g; after the assembly is completed, the reducing gas such as helium gas or argon gas, etc., is continuously supplied from the quartz cooling tube 14, so that the furnace cavity is placed in a reducing atmosphere; after supplying gas for 5 to 10 minutes, the graphite resistance heating system is turned on, and the heat field setting temperature is set to 1500 to 1600°C, and the upper heater 11 and the lower the heater 12 heats the overall thermal field and the silicon raw material to provide sufficient heat for the thermal field to rapidly melt the added silicon material; when the temperature is stable at the set temperature and the silicon material is completely melted, new silicon material is slowly added from the feeding port 5 so that the melted silicon material flows via the overflow port 2 to the first overflow surface 3; as the silicon material gradually increases, the melted silicon gradually increases, and the silicon material flows from a slope to the second overflow surface 4. At this time, the silicon, after being buffered by the first overflow surface, will flow into the crystal growth zone in a relatively smooth state.

Next, in a step of horizontally drawing silicon wafer S2, since the heat insulating baffle 17 is placed between the jet 15 and the heating region, the entire thermal field is divided into the hot zone 8 and the cold zone 9, and the hot zone 8 has an average temperature of 1500 to 1600°C, and the cold zone 9 has an average temperature of 800 to 1000°C. When the silicon material is about to reach the cold zone (i.e., the boundary of the hot zone), the seed plate is inserted into the furnace cavity (depending on the feeding rate, an arrival time needs to be adjusted), and at the same time the feeding rate is slowed down to ensure the melt to flow slowly in a thin layer toward the seed crystal; when the melt is in contact with the seed ingot, the seed is pulled in a reverse direction, and at the same time the jet 15 is turned on. The flow rate of the jet 15 is set to, for example, 0 to 3m3/min, and the jet gas is pure inert gas of 600-1000°C or a mixed gas of two inert gases mixed in a certain proportion; a gas pump is turned on at the same time as the jet 15 is turned on, and the gas is pumped outward through the quartz exhaust tube 13 to ensure that the internal pressure will not be too large, and the gas will not be too much, and the quartz cooling tube 14 is always kept in a ventilated state, and the silicon wafer can be continuously drawn horizontally.

## Claims

1. A silicon wafer horizontal growth apparatus, comprising:
a casing forming a cavity;
a crucible, located in the cavity and having a melting zone, an overflow port, a first overflow surface and a second overflow surface;
a feeding assembly for adding silicon raw material to the melting zone at a feeding rate adjustable;
a heating assembly comprising two movable heaters, the two movable heaters being disposed on the upper and lower sides of the crucible respectively at a certain interval with the crucible;
a thermal insulation component for maintaining a temperature in the cavity;
a gas flow assembly comprising a jet, a gas conductive graphite member, a quartz exhaust tube, and a quartz cooling tube, wherein the jet is located above the second overflow surface, the gas conductive graphite member is mounted on the bottom of the crucible, the quartz cooling tube is nested outside the quartz exhaust tube, and the quartz exhaust tube is connected with the gas conductive graphite member; and
a heat insulating baffle located above the second overflow surface for isolating the heating assembly from the jet so that the cavity is divided into two temperature zones of a hot zone and a cold zone.

2. The apparatus according to claim 1, further comprising a receiving crucible located below an edge of the second overflow surface of the crucible.

3. The apparatus according to claim 1, wherein a heat conductive graphite plate is disposed between the heater and the crucible.

4. The apparatus according to any one of claims 1-3, wherein a distance between the heater and the crucible is in a range of 1 to 5 mm.

5. The apparatus according to any one of claims 1-3, wherein a distance between the jet and the second overflow surface is greater than 7 mm.

6. The apparatus according to any one of claims 1-3, wherein the heat insulating baffle has a thickness in a range of 1 to 3 cm.

7. The apparatus according to any one of claims 1-3, wherein a distance between the heat insulating baffle and the second overflow surface is in a range of 2 to 6 mm.

8. The apparatus according to any one of claims 1-3, wherein the jet includes a gas inflow tube, a jet tube and a support tube, wherein two ends of the jet tube are respectively connected to the inflow tube and the support tube through a connecting member, and the jet tube has a double-layered structure with an outer layer being made of an isostatically pressed graphite material, and an inner layer being made of ceramic or high-density graphite material, and the jet tube is provided with a row of holes or a slit.

9. A method for horizontal growth of a silicon wafer, comprising:
a step of melting a silicon raw material, including: adding a silicon raw material to a melting zone of a crucible through a feeding assembly; introducing a reducing gas into a cavity through a quartz cooling tube to place the cavity in a reducing atmosphere; then heating by a heater; when the temperature is stabilized at a set temperature and the silicon material is completely melted, a new silicon material is slowly added through a feeding port, so that the molten silicon material flows from an overflow port to a first overflow surface; as the silicon material gradually increases, the molten silicon gradually increases accordingly, the silicon material overflows to a second overflow surface smoothly; and
a step of horizontal drawing of the silicon wafer, including: when the silicon material is about to reach a boundary between a cold zone and hot zone, a seed plate is inserted into the cavity, and at the same time, a rate of feeding is slowed down, so that a melted material flows slowly to the seed plate in a form of a thin layer; when the melted material contacts the seed plate, the seed plate is pulled backward, and at the same time, a jet and an air pump are turned on, and a quartz exhaust tube is exhausted by pumping outwardly, and the quartz cooling tube is always kept in a ventilated state.

10. The method according to claim 9, wherein an average temperature of the hot zone is in a range of 1500°C to 1600°C, and an average temperature of the cold zone is in a range of 800°C to 1000°C.

## Patentansprüche

1. Vorrichtung zum horizontalen Wachstum von Siliziumwafern, umfassend:
ein Gehäuse, das einen Hohlraum bildet;
einen Tiegel, der sich im Hohlraum befindet und eine Schmelzzone, eine Überlauföffnung, eine erste Überlauffläche und eine zweite Überlauffläche aufweist;
eine Zufuhranordnung zum Hinzufügen von Siliziumrohmaterial zu der Schmelzzone mit einer einstellbaren Zufuhrrate;
eine Heizanordnung mit zwei beweglichen Heizelementen, wobei die zwei beweglichen Heizelemente an der Ober- bzw. Unterseite des Tiegels in einem bestimmten Abstand zum Tiegel angeordnet sind;
eine Wärmedämmkomponente zum Aufrechterhalten einer Temperatur in dem Hohlraum;
eine Gasströmungsanordnung, umfassend eine Düse, ein gasleitendes Graphitelement, ein Abgasrohr aus Quarz und ein Kühlrohr aus Quarz, wobei sich die Düse über der zweiten Überlauffläche befindet, das gasleitende Graphitelement am Boden des Tiegels montiert ist, das Kühlrohr aus Quarz außerhalb das Abgasrohr aus Quarz umgibt und das Abgasrohr aus Quarz mit dem gasleitenden Graphitelement verbunden ist; und
ein wärmeisolierendes Prallblech, das sich über der zweiten Überlauffläche befindet, um die Heizanordnung von der Düse zu isolieren, so dass der Hohlraum in zwei Temperaturzonen, eine heiße Zone und eine kalte Zone, unterteilt ist.

2. Vorrichtung nach Anspruch 1, ferner umfassend einen Aufnahmetiegel, der sich unterhalb einer Kante der zweiten Überlauffläche des Tiegels befindet.

3. Vorrichtung nach Anspruch 1, wobei eine wärmeleitende Graphitplatte zwischen dem Heizelement und dem Tiegel angeordnet ist.

4. Vorrichtung nach einem der Ansprüche 1 bis 3, wobei ein Abstand zwischen dem Heizelement und dem Tiegel in einem Bereich von 1 bis 5 mm liegt.

5. Vorrichtung nach einem der Ansprüche 1 bis 3, wobei ein Abstand zwischen der Düse und der zweiten Überlauffläche größer als 7 mm ist.

6. Vorrichtung nach einem der Ansprüche 1 bis 3, wobei das wärmeisolierende Prallblech eine Dicke im Bereich von 1 bis 3 cm aufweist.

7. Vorrichtung nach einem der Ansprüche 1 bis 3, wobei ein Abstand zwischen dem wärmeisolierenden Prallblech und der zweiten Überlauffläche in einem Bereich von 2 bis 6 mm liegt.

8. Vorrichtung nach einem der Ansprüche 1 bis 3, wobei die Düse ein Gaseinströmrohr, ein Strahlrohr und ein Stützrohr umfasst, wobei zwei Enden des Strahlrohrs jeweils mit dem Einströmrohr und dem Stützrohr durch ein Verbindungselement verbunden sind, und das Strahlrohr eine doppelschichtige Struktur aufweist, wobei eine äußere Schicht aus einem isostatisch gepressten Graphitmaterial und eine innere Schicht aus Keramik oder hochdichtem Graphitmaterial besteht, und das Strahlrohr mit einem Lochreihe oder einen Schlitz versehen ist.

9. Verfahren zum horizontalen Wachstum eines Siliziumwafers, umfassend:
einen Schritt des Schmelzens eines Siliziumrohmaterials, umfassend: Hinzufügen eines Siliziumrohmaterials zu einer Schmelzzone eines Tiegels durch eine Zufuhranordnung; Einführen eines reduzierenden Gases in einen Hohlraum durch ein Kühlrohr aus Quarz, um den Hohlraum in eine reduzierende Atmosphäre zu bringen; dann Erhitzen durch ein Heizelement; wenn die Temperatur bei einer eingestellten Temperatur stabilisiert ist und das Siliziummaterial vollständig geschmolzen ist, wird ein zusätzliches Siliziummaterial langsam durch eine Zufuhröffnung hinzugefügt, so dass das geschmolzene Siliziummaterial von einer Überlauföffnung zu einer ersten Überlauffläche fließt; wenn das Siliziummaterial allmählich zunimmt, nimmt das geschmolzene Silizium entsprechend allmählich zu, fließt das Siliziummaterial glatt zu einer zweiten Überlauffläche über; und
einen Schritt des horizontalen Ziehens des Siliziumwafers, umfassend: wenn das Siliziummaterial eine Grenze zwischen einer kalten Zone und einer heißen Zone erreicht, wird eine Keimplatte in den Hohlraum eingeführt, und gleichzeitig wird die Zufuhrrate verlangsamt, so dass ein geschmolzenes Material in Form einer dünnen Schicht langsam zur Keimplatte fließt; wenn das geschmolzene Material die Keimplatte berührt, wird die Keimplatte nach hinten gezogen, und werden gleichzeitig eine Düse und eine Luftpumpe eingeschaltet, und wird ein Absaugrohr aus Quarz durch Pumpen nach außen entleert, und ist das Kühlrohr aus Quarz immer in belüftetem Zustand aufbewahrt.

10. Verfahren nach Anspruch 9, wobei eine durchschnittliche Temperatur der heißen Zone in einem Bereich von 1500°C bis 1600°C liegt und eine durchschnittliche Temperatur der kalten Zone in einem Bereich von 800°C bis 1000°C liegt.

## Revendications

1. Appareil pour croissance horizontale de plaquettes de silicium, comprenant:
une enveloppe qui forme une cavité;
un creuset, situé dans la cavité et ayant une zone de fusion, un orifice de débordement, une première surface de débordement et une seconde surface de débordement;
un ensemble d'alimentation pour ajouter de la matière première de silicium à la zone de fusion à une vitesse d'alimentation réglable;
un ensemble de chauffage comprenant deux réchauffeurs mobiles, les deux réchauffeurs mobiles étant disposés sur les faces supérieure et inférieure du creuset respectivement à un certain intervalle avec le creuset;
un composant d'isolation thermique pour maintenir une température dans la cavité;
un ensemble d'écoulement de gaz comprenant un jet, un élément en graphite conducteur de gaz, un tube d'échappement en quartz et un tube de refroidissement en quartz, dans lequel le jet est situé au-dessus de la seconde surface de débordement, l'élément en graphite conducteur de gaz est monté sur le fond du creuset, le tube de refroidissement en quartz entoure l'extérieur du tube d'échappement en quartz, le tube d'échappement en quartz est connecté à l'élément en graphite conducteur de gaz; et
un baffle calorifuge situé au-dessus de la deuxième surface de débordement pour isoler l'ensemble de chauffage du jet de sorte que la cavité se divise en deux zones de temperature, c'est à dire une zone chaude et une zone froide.

2. Appareil selon la revendication 1, comprenant en outre un creuset récepteur situé en dessous d'un bord de la deuxième surface de débordement du creuset.

3. Appareil selon la revendication 1, dans lequel une plaque thermoconductrice en graphite est disposée entre le réchauffeur et le creuset.

4. Appareil selon l'une quelconque des revendications 1 à 3, dans lequel une distance entre le réchauffeur et le creuset est dans une plage de 1 à 5 mm.

5. Appareil selon l'une quelconque des revendications 1 à 3, dans lequel une distance entre le jet et la seconde surface de débordement est supérieure à 7 mm.

6. Appareil selon l'une quelconque des revendications 1 à 3, dans lequel le baffle calorifuge a une épaisseur dans une plage de 1 à 3 cm.

7. Appareil selon l'une quelconque des revendications 1 à 3, dans lequel une distance entre le baffle calorifuge et la seconde surface de dé bordementest dans une plage de 2 à6 mm.

8. Appareil selon l'une quelconque des revendications 1 à 3, dans lequel le jet comprend un tube d'admission de gaz, un tube à jet et un tube de support, dans lequel deux extrémités du tube à jet sont respectivement connectées au tube d'admission et au tube de support par un élément de connexion, et le tube à jet a une structure à double couche avec une couche externe étant réalisée en matériau graphite pressé isostatiquement, et une couche interne étant réalisée en céramique ou matériau graphite à haute densité, et le tube à jet est pourvu d'un rangée de trous ou d'une fente.

9. Procédé pour croissance horizontale d'une plaquette de silicium, comprenant:
une étape de fusion d'une matière première de silicium, comprenant: l'ajout d'une matière première de silicium à une zone de fusion d'un creuset à travers un ensemble d'alimentation; introduction d'un gaz réducteur dans une cavité à travers un tube de refroidissement en quartz pour mettre la cavité en une atmosphère réductrice; puis chauffage par un réchauffeur; lorsque la température est stabilisée à une température définie et que le matériau de silicium est complètement fondu, un matériau additionnel de silicium est lentement ajouté par un orifice d'alimentation, de sorte que le matériau de silicium fondu s'écoule d'un orifice de débordement vers une première surface de débordement; à mesure que le matériau de silicium augmente progressivement, le silicium fondu augmente progressivement en conséquence, le matériau de silicium déborde doucement vers une seconde surface de débordement; et
une étape d'étirage horizontal de la plaquette de silicium, comprenant: lorsque le matériau de silicium est sur le point d'atteindre une limite entre une zone froide et une zone chaude, une plaque d'ensemencement est insérée dans la cavité, et en même temps, une vitesse d'alimentation est ralenti, de sorte qu'un matériau fondu s'écoule lentement vers la plaque d'ensemencement sous la forme d'une couche mince; lorsque le matériau fondu entre en contact avec la plaque d'ensemencement, celle-ci est tirée vers l'arrière, et en même temps, un jet et une pompe à air sont mis en marche, et un tube d'échappement en quartz est évacué par pompage vers l'extérieur, et le tube de refroidissement en quartz est toujours conservé dans un état ventilé.

10. Procédé selon la revendication 9, dans lequel une température moyenne de la zone chaude est comprise entre 1500°C et 1600°C, et une température moyenne de la zone froide est comprise entre 800°C et 1000°C.
